Europäisches Patentamt

European Patent Office

Office européen des brevets

(19)

(11) Veröffentlichungsnummer: **0 210 473 B1**

## (12) EUROPÄISCHE PATENTSCHRIFT

(45) Veröffentlichungstag der Patentschrift: **23.10.91**

(51) Int. Cl.⁵: **H01J 37/34**

(21) Anmeldenummer: **86109209.6**

(22) Anmeldetag: **05.07.86**

(54) **Zerstäubungskathode nach dem Magnetronprinzip.**

(30) Priorität: **01.08.85 DE 3527626**

(43) Veröffentlichungstag der Anmeldung:
**04.02.87 Patentblatt 87/06**

(45) Bekanntmachung des Hinweises auf die
Patenterteilung:
**23.10.91 Patentblatt 91/43**

(84) Benannte Vertragsstaaten:
**AT BE CH DE FR GB IT LI LU NL SE**

(56) Entgegenhaltungen:
**DE-A- 3 411 536
DE-A- 3 429 988
GB-A- 2 096 177
US-A- 4 422 896
US-A- 4 486 287**

(73) Patentinhaber: **LEYBOLD AKTIENGESELL-
SCHAFT
Wilhelm-Rohn-Strasse 25
W-6450 Hanau am Main 1(DE)**

(72) Erfinder: **Geisler, Michael, Dr. Phys.
Chatilloner Strasse 29
W-6480 Wächtersbach(DE)**
Erfinder: **Kieser, Jörg, Dr. Phys.
Goldbergstrasse 4a
W-8755 Albstadt(DE)**
Erfinder: **Kukla, Reiner
Mergenswiesenweg 15
W-6450 Hanau 9(DE)**

(74) Vertreter: **Zapfe, Hans, Dipl.-Ing.
Am Eichwald 7
W-6056 Heusenstamm 2 Rembrücken(DE)**

## Beschreibung

Zerstäubungskatoden für die Produktbeschichtung sind mit einer Vielzahl von geometrischen Formen der Zerstäubungsflächen bekannt. Allen Systemen ist gemeinsam, daß über der Zerstäubungsfläche durch ein dahinterliegendes Magnetsystem ein geschlossener Tunnel aus magnetischen Feldlinien erzeugt wird, der zur Konzentration des Plasmas dient und die für die Ausbildung einer Glimmentladung erforderliche Ionisationswahrscheinlichkeit auch bei niedrigeren Drücken beträchtlich erhöht. Die Folge ist in jedem Falle, bezogen auf das gleiche zu zerstäubende Material bei im übrigen gleichen Verfahrensparametern - eine wesentlich höhere Zerstäubungsrate als ohne Magnetfeld-Unterstützung.

Unter dem Begriff "magnetischer Tunnel" soll die tunnelförmige Schließung eines räumlich begrenzten Bereichs durch magnetische Feldlinien verstanden werden, unabhängig davon, ob die Feldlinien einen gekrümmten, bis zur Zerstäubungdfläche ausreichenden, Verlauf haben oder einen nicht gekrümmten Verlauf, der lediglich den Abschluß einer trogförmigen Nut darstellt.

Der Ausdruck "Vorsprung" ist dabei im Hinblick auf die Ebene "E-E" zu sehen, in der die Zerstäubungsfläche liegt. Die Richtung der Vorsprünge erstreckt sich infolgedessen normal zu dieser Ebene E-E, zumindest in Bezug auf die jeweils der Zerstäubungsfläche zugekehrte Wandfläche eines jeden Vorsprungs. Der Ausdruck "Vorsprung" bezieht sich weiterhin auf den ursprünglichen (jungfräulichen) Zustand des Targets und ist nicht zu verwechseln mit den beim Stande der Technik beiderseits des Erosionsgrabens stehen bleibenden Erhöhungen. Diese können schon wegen ihrer schräg zu der genannten Ebene E-E verlaufenden Wandflächen nicht die Bedingungen eines zuverlässigen Einschlusses des Plasmas erfüllen. Dabei bilden die Vorsprünge und der die Zerstäubungsfläche aufweisende Teil des Targets eine elektrische und mechanische Einheit, im Gegensatz beispielsweise zum Stand der Technik nach der DE-OS 34 11 536, bei der die beiderseits der Targetränder vorspringenden Gehäuseteile vom Target isoliert sind, so daß sie sich auf ein durch die Verfahrensparameter bedingtes Zwischenpotential einstellen können. Für die Höhe der Vorsprünge genügt in vorteilhafter Weise ein Maß von wenigen Dunkelraum-Abständen, also beispielsweise von etwa 8 mm.

Die Angabe, daß ein wesentlicher Teil der Magnetfeldlinien in im wesentlichen senkrechter Richtung aus der einen Wandfläche austritt und in die andere Wandfläche wieder eintritt, ist nicht streng unter dem Blickwinkel von 90 Grad zu sehen. Die Erfahrung hat gezeigt, daß die Abweichung von bis zu etwa 15 bis 20 Grad von diesem Winkel unschädlich ist, so daß der Aus- bzw. Eintrittswinkel durchaus auch den Wert von 70 Grad haben kann.

Eine Zerstäubungskatode der eingangs beschriebenen Gattung ist durch die US-PS 4 486 287 bekannt. Bei ihr sind jedoch die Permanentmagnete quer zu den Vorsprüngen, d.h. parallel zur Zerstäubungsfläche magnetisiert. Bei einer kreisringförmigen Zerstäubungsfläche ist die Magnetisierungsrichtung also radial. Dies führt einmal zu einem größeren Außendurchmesser der Katode, zum anderen wird im Zentrum der Katode ein relativ großes Volumen von den Permanentmagneten und den sie mit dem Grundkörper verbindenden Jochen eingenommen, so daß kleine Katoden praktisch nicht herzustellen sind. Für längliche bzw. rechteckige Katoden gelten analoge Überlegungen.

Ein weiterer Nachteil besteht darin, daß sich bei dem bestimmungsgemäßen Verbrauch des Targetmaterials der Abstand der jeweiligen, momentanen Zerstäubungsfläche von dem Magnetfeld und damit die Stärke des das Plasma einschliessenden Magnetfelds ändert. Dies läßt sich meßtechnisch durch ein unerwünschtes Wandern der Kennlinie des Magnetrons erfassen und äußert sich praktisch in veränderlichen Zerstäubungs- und Niederschlagsraten (auf den Substraten).

Die GB-A-2 096 117 offenbart Zerstäubungskatoden mit drei Elektroden, von denen eine als Elektronen-Emitter ausgebildet ist, um zusätzliche, für die Ionisation der Gasatmosphäre benötigte Elektronen zu liefern. Derartige "Trioden-Systeme" bedingen einen an beiden Enden offenen magnetischen Tunnel, an dessen einem Ende sich der Elektronen-Emitter und an dessen anderem Ende sich der Elektronen-Kollektor befindet. Das Target ist infolgedessen nur an zwei Langseiten von Magnetpolen bzw. Polschuhen entgegengesetzter Polarität umgeben, und es ist aus diesem Grunde nicht möglich, die Polschuhe auf dem Umfang des Targets zu schließen. Wegen des Konzentrationsgefälles der Elektronen an den Enden des magnetischen Tunnels muß die Anordnung deutlich länger gewählt werden als die Größe bzw. Breite eines Substrates. Trioden-Systeme zeichnen sich durch eine aufwendige Bauweise und eine erhebliche Wärmeentwicklung durch den Elektronen-Emitter aus.

Durch die US-A-4 422 896 ist es bekannt, die nicht zur Zerstäubung vorgesehenen Polschuhe eines Magnetsystems, das zur Ausbildung einer magnetischen Falle für eine Plasmaentladung dient, innerhalb einer auf Erdpotential liegenden Abschirmung unterzubringen. Weitere übereinstimmende Merkmale bezüglich einer Targetausbildung mit Vorsprüngen etc. sind jedoch nicht vorhanden.

Durch die DE-A-3 411 536 ist es bekannt, vor den Permanentmagneten durch Luftspalte getrennte weichmagnetische Körper anzuordnen, die eine Veränderung der Feldlinienverteilung bewirken. Dadurch sollen Targets mit Vorsprüngen vermieden werden. Auch durch diese Maßnahme nehmen jedoch wieder die Querabmessungen der ganzen Katode zu.

Der Erfindung liegt die Aufgabe zugrunde, die Querabmessung der bekannten Magnetronkatoden zu verringern und die Herstellung kleiner bzw. schmaler Katoden zu ermöglichen.

Die Lösung der gestellten Aufgabe erfolgt bei der eingangs angegebenen Zerstäubungskatode erfindungsgemäß durch die im Kennzeichen des Patentanspruchs 1 angegebenen Merkmale.

Bei den "Polflächen" handelt es sich um diejenigen Flächen des Magnetsystems, aus denen die Feldlinien austreten oder in die sie wieder eintreten. Die Polflächen werden dabei durch die dem Target zugekehrten Oberflächen weichmagnetischer Polschuhe gebildet, die sinngemäß auch als "Diffusoren" (für die Feldlinien) bezeichnet werden können.

Die weichmagnetischen Polschuhe bzw. "Diffusoren" führen zu folgenden Vorteilen: Die üblicherweise verwendeten Permanentmagnete weisen eine sehr hohen Gradienten in der Feldstärke auf. Dieser Effekt wird durch die weichmagnetischen Polschuhe erheblich verringert, so daß damit die Zerstäubung sehr dicker Targets möglich ist, ohne daß sich die Betriebsbedingungen in unzulässiger Weise verändern und ohne daß eine mechanische Verstellung des Magnetsystems gegenüber dem Target notwendig wäre. Weiterhin benötigt der Erfindungsgegenstand bei gleich großer Zerstäubungsfläche sehr viel weniger Platz als ein Magnetron mit radialer Magnetisierungsrichtung. Dies führt wiederum bei langgestreckten Katoden mit geradlinigen Zerstäubungsflächen zu einem sehr viel kleineren Minimalabstand zwischen diesen geradlinigen Zerstäubungsflächen, so daß eine wesentlich größere Freiheit bei der Abstimmung der Niederschlagsratenverteilung gegeben ist.

Herkömmliche Magnetronkatoden können ohne übermäßig großen Aufwand in den Erfindungsgegenstand umgebaut werden, da auf die Permanentmagnete nur die erfindungsgemäßen weichmagnetischen Polschuhe aufgesetzt werden müssen. Durch Montage von weichmagnetischen Polschuhen mit geänderten Abmessungen läßt sich die gesamte Magnetronkatode schneller und einfacher auf Targets mit einer anderen Dicke umrüsten. Ferner besteht der Vorteil, daß durch eine besondere Formgebung der einfach zu bearbeitenden Weicheisen-Polschuhe die geometrische Form des Magnetfeldes bzw. des magnetischen Tunnels leichter optimierbar ist, und schließlich gewährleistet der Erfindungsgegenstand eine bessere Kühlungsmöglichkeit der als wärmeempfindlich bekannten Permanentmagnete, da diese Magnete an den thermisch weniger exponierten Stellen plaziert werden können.

Wohlgemerkt, die Erfindung bezieht sich auf den Einsatz von Targets aus amagnetischem Material, und es ist bekannt, zum Zwecke einer Zerstäubung von Targets aus ferromagnetischem Material entweder Magnetsysteme auf der Targetvorderseite anzubringen, oder dem Target durch mindestens einen Luftspalt getrennte, vorspringende Polschuhe oder zum Katodengrundkörper gehörende Vorsprünge aus gleichfalls ferromagnetischem Material zuzuordnen, um überhaupt die Voraussetzungen dafür zu schaffen, auf der Targetvorderfläche mindestens einen geschlossenen Tunnel aus Magnetfeldlinien zu erzeugen. Die Feldlinien eines solchen magnetischen Tunnels haben jedoch wegen der engen Nachbarschaft der durch mindestens einen Luftspalt getrennten Teile zumindest überwiegend einen relativ stark gekrümmten Verlauf, so daß bei derartigen bekannten Systemen der Erosionsgraben auf einen engen Bereich begrenzt ist.

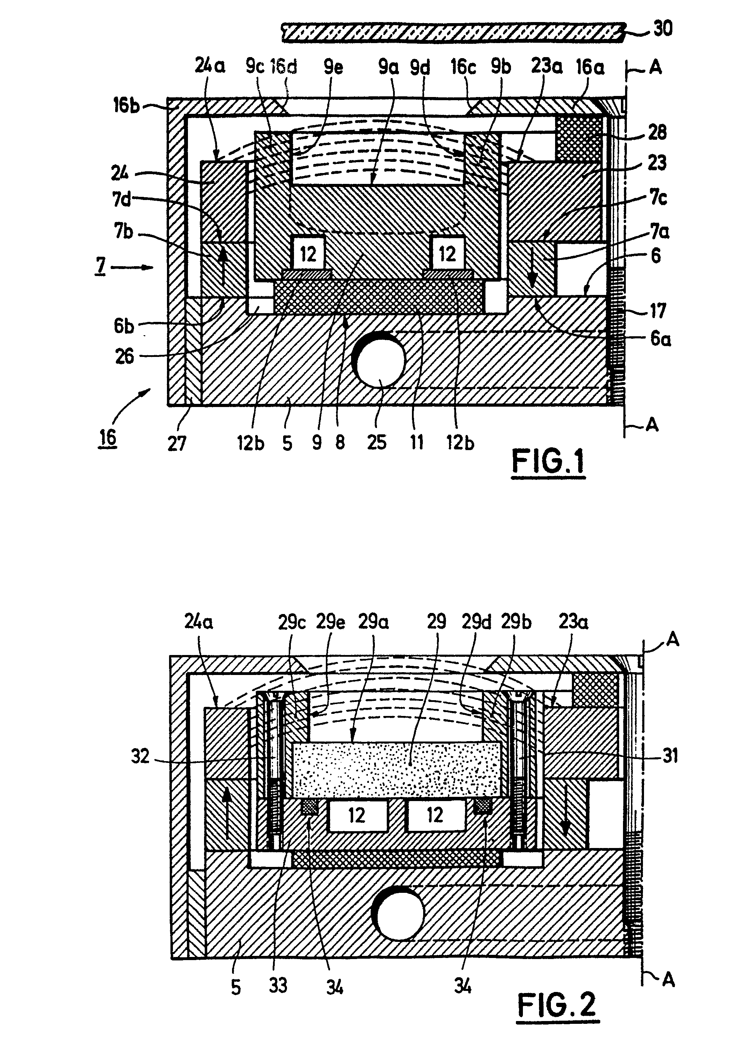

Ausführungsbeispiele des Erfindungsgegenstandes werden nachfolgend anhand der Figuren 1 bis 6 näher erläutert.

**Es zeigen:**

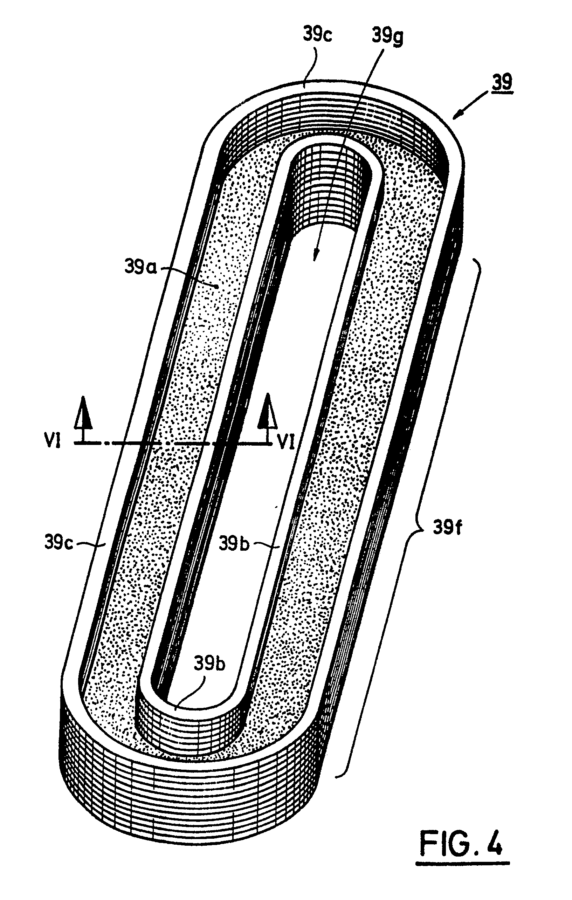

Figuren 1 und 2
je einen halben Axialschnitt durch unterschiedliche Ausführungsbeispiele der wesentlichen Teile einer Zerstäubungskatode,
Figur 3
ein Diagramm mit Kennlinien einer Zerstäubungskatode mit der erfindungsgemäßen Targetausbildung,
Figur 4
eine perspektivische Ansicht eines Targets für die Beschichtung großflächiger Substrate,
Figur 5
einen Schnitt entlang der Linie VI-VI in Figur 4, und
Figur 6
einen Axialschnitt durch eine einbaufertige Zerstäubungskatode mit allen Einzelheiten einschließlich der Isolatoren für die verschiedenen Potentialdifferenzen.

In Figur 1 ist ein Katodengrundkörper 5 dargestellt, der aus einem ferromagnetischen Werkstoff besteht und gleichzeitig das Magnetjoch für das nachfolgend näher beschriebene Magnetsystem bildet. Der Katodengrundkörper 5 besitzt eine obere Ebene 6, in der ringförmig geschlossene Auflageflächen 6a und 6b für die Permanentmagnete des Magnetsystems 7 liegen. Es handelt sich um einen inneren Ringmagneten 7a und eine geschlossene äußere Reihe von Stabmagneten 7b, die sämtlich in Bezug auf die Achse A-A des Systems axial magnetisiert sind, und zwar derart, daß die Polungsrichtung des inneren Ringmagneten 7a umgekehrt zu derjenigen der äußeren Stabmagneten 7b verläuft. Die Pollage ist in Figur 1 eingezeichnet. Die Magnete besitzen auf der dem Katodengrundkörper 5 abgekehrten Seite Endflächen 7c und 7d, die in einer gemeinsamen Ebene liegen.

Auf den Endflächen 7c und 7d liegen wiederum weichmagnetische Polschuhe 23 und 24 auf, wobei die Anordnung derart getroffen ist, daß zwischen den Permanentmagneten und den Polschuhen ein hohlzylindrischer Raum 26 gebildet wird, der um die Achse A-A herum geschlossen verläuft und nach oben hin offen ist.

Zwischen den Auflageflächen 6a und 6b liegt eine ringförmig geschlossene Auflagefläche 8, die den Boden des hohlzylindrischen Raums 26 bildet. Auf dieser Auflagefläche 8 ruht ein Isolierkörper 11, der zur Abstützung eines Targets 9 dient. Dieses Target bildet das Ausgangsmaterial für die zu erzeugenden Schichten, die auf einem Substrat 30 niedergeschlagen werden sollen, das hier nur andeutungsweise dargestellt ist. Das Target 9 besitzt eine ebene Zerstäubungsfläche 9a, die beiderseits von zwei in sich geschlossenen, konzentrisch ineinanderliegenden Vorsprüngen 9b und 9c begrenzt ist, die aus dem gleichen amagnetischen Werkstoff bestehen wie der übrige Teil des Targets 9. Die Vorsprünge 9b und 9c besitzen aufeinander zu gerichtete Wandflächen 9d und 9e, deren Erzeugende senkrecht zur Zerstäubungsfläche 9a verlaufen. Im vorliegenden Falle handelt es sich um Zylinderflächen.

Die Polschuhe 23 und 24 besitzen im Bereich ihrer Stirnseiten sowie im Bereich ihrer den hohlzylindrischen Raum 26 begrenzenden Wandflächen Polflächen 23a und 24a, wobei aus Platzgründen nur die stirnseitigen Teile der Polflächen beziffert sind. Die Polflächen 23a und 24a sind beiderseits der Vorsprünge 9b und 9c und der zwischen ihnen liegenden Zerstäubungsfläche 9a soweit über die Ebene der Zerstäubungsfläche 9a in Zerstäubungsrichtung vorgezogen, daß ein wesentlicher Teil der Magnetfeldlinien in im wesentlichen senkrechter Richtung aus der einen Wandfläche 9e des einen Vorsprungs 9c austritt und nach dem Überqueren der Zerstäubungsfläche 9a in die andere, gegenüberliegende Wandfläche 9d des anderen Vorsprungs 9b in im wesentlichen senkrechter Richtung wieder eintritt.

Dadurch werden die weiter oben beschriebenen vorteilhaften Wirkungen bezüglich einer äußerst gleichmäßigen Erosion der Zerstäubungsfläche 9a sowie einer hohen mittleren Zerstäubungsrate erreicht. Der Zerstäubungsvorgang wird zweckmäßig dann abgebrochen, wenn die ursprüngliche Zerstäubungsfläche 9a an der gestrichelten Linie darunter angelangt ist. Die von den Polflächen 23a zu den Polflächen 24a verlaufenden magnetischen Feldlinien sind hinsichtlich ihres wesentlichen Teils oberhalb der Zerstäubungsfläche 9a gleichfalls gestrichelt dargestellt.

Um die bei der Zerstäubung in das Target 9 eintretende Wärmemenge abführen zu können, sind in der Unterseite des Targets 9 Kühlkanäle 12 angeordnet, die über einen großen Teil ihrer Länge konzentrisch verlaufen und an der Unterseite des Targets 9 durch Ringscheiben 12b verschlossen sind. Auch der Katodengrundkörper 5 ist in analoger Weise mit einem Kühlkanal 25 ausgestattet.

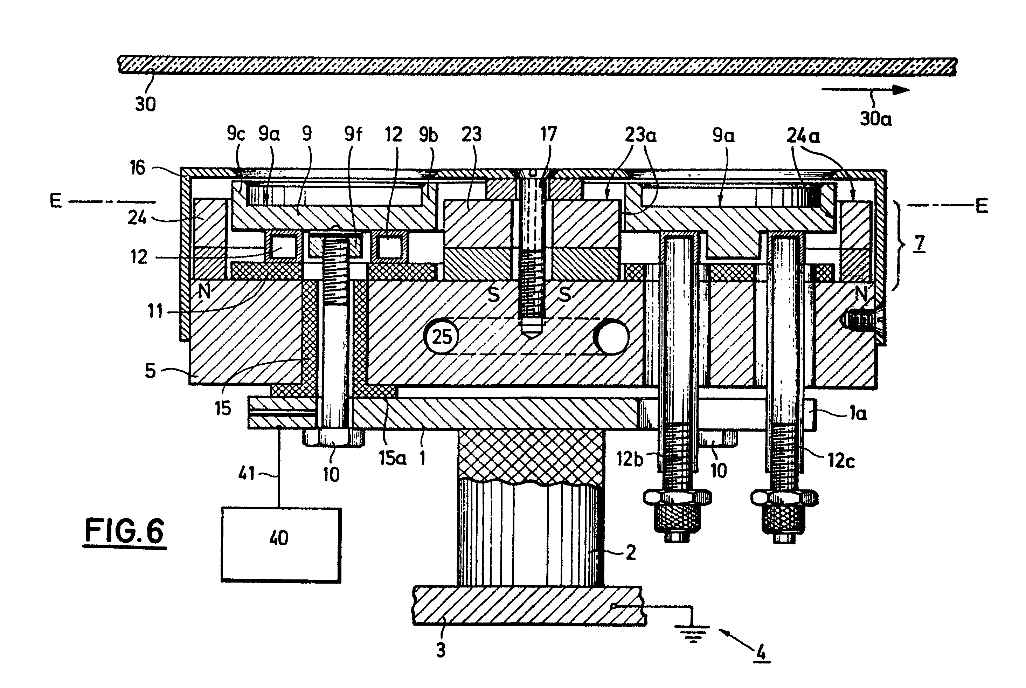

Das Magnetsystem 7 ist von einer Abschirmung 16 umgeben, die aus einem scheibenförmigen zentralen Teil 16a und einem ringförmigen peripheren Teil 16b besteht. Der periphere Teil 16b ist über einen Distanzring 27 mit dem Katodengrundkörper 5 elektrisch leitend verbunden, während der zentrale Teil 16a über eine Schraube 17 elektrisch leitend mit dem Katodengrundkörper 5 verbunden ist. Wie aus Figur 1 zu erkennen ist, übergreifen die einander gegenüberliegenden Ränder 16c und 16d auch die auf das Substrat 30 zu gerichteten Stirnseiten der Vorsprünge 9b und 9c. Aufgrund der in Verbindung mit Figur 6 noch näher beschriebenen Zusammenhänge unterbleibt dabei die Ausbildung einer Glimmentladung im Innern der Abschirmung 16, so daß es auch nicht zu einem Zerstäuben der genannten Stirnseiten der Vorsprünge kommt. Durch die Verhinderung einer Sichtverbindung von außen nach innen wird auch wirksam verhindert, daß sich elektrisch leitendes Material auf dem Isolierkörper 11 niederschlagen kann. Der axiale Abstand des zentralen Teils 16a gegenüber dem Vorsprung 9d wird durch einen Distanzring 28 festgelegt.

In Figur 2 ist - abweichend von Figur 1 - folgendes dargestellt: Das Target 29 besitzt in diesem Falle Vorsprünge 29b und 29c aus einem artfremden Material, nämlich aus nicht-rostendem Stahl (Chrom-Nickel-Stahl) mit gleichfalls amagnetischen Eigenschaften. Die Vorsprünge 29b und 29c dienen hierbei gleichzeitig als Klemmleisten für den die Zerstäubungsfläche 29a aufweisenden Teil des Targets 29. Die Vorsprünge 29b und 29c werden zusammen mit dem Target 29 durch konzentrische Reihen von Schrauben 31 und 32 gegen eine Auflageplatte 33 verspannt, in der im wesentlichen konzentrische Kühlkanäle 12 sowie beiderseits dieser Kühlkanäle Ringnuten 34 mit eingelegten Dichtungen (nicht näher bezeichnet) angeordnet sind. Der Wärmeübergang kann noch dadurch verbessert werden, daß die die Kühlkanäle 12 verschliessende Unterseite des Targets 29 an dieser Stelle mit Rippen versehen ist, die die Oberfläche vergrößern. Das Target 29 liegt alsdann mit den Vorsprüngen 29b und 29c und der Auflageplatte 33 in analoger Weise auf dem Isolierkörper 11 auf, wie dies auch in Figur 1 dargestellt ist. Die Befestigung wird im einzelnen noch anhand von Figur 6 näher erläutert. Eine Anordnung nach Figur 2 kommt bevorzugt für gepreßte bzw. gesinterte Targets 29 bzw. für solche aus dielektrischen Materialien in Frage. Das Wirkungsprinzip ist jedoch im wesentlichen unverändert, wie insbesondere auch aus dem gestrichelt eingezeichneten Verlauf der magnetischen Feldlinein hervorgeht.

Der weichmagnetische Katodengrundkörper, der hier stellvertretend für das Magnetjoch steht, kann jedoch auch unabhängig von dem Magnetjoch ausgebildet sein und beispielsweise aus Kupfer bestehen.

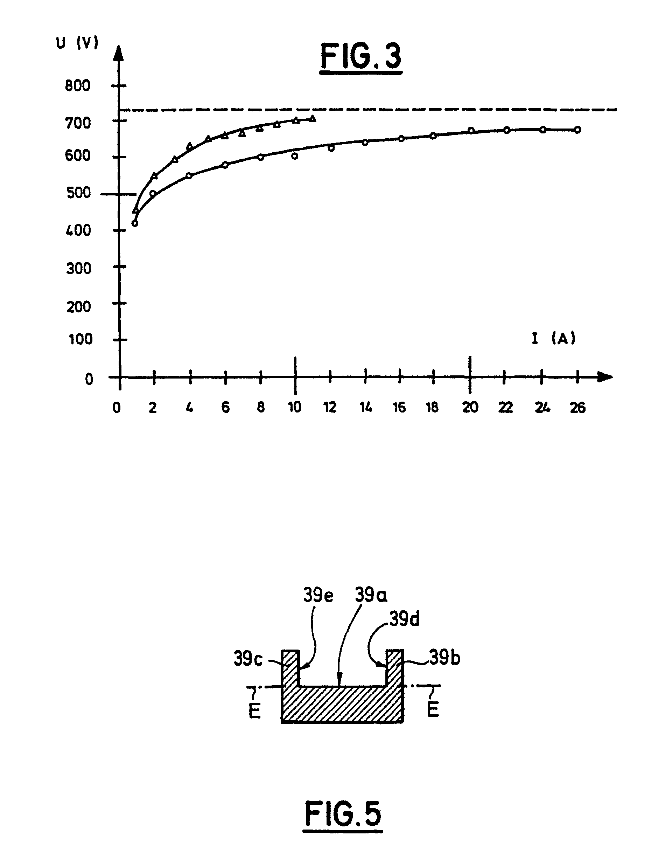

Figur 3 zeigt die sogenannten "Magnetron-Kennlinien" eines Magnetrons gemäß Figur 1. Hierbei bestand das Target aus Kupfer, und die mittlere Feldstärke betrug in etwa 1 mm Abstand über der Zerstäubungsfläche (in Parallelrichtung hierzu gemessen) im Mittel 17,3 kA/m. Die Durchdringungswinkel der Magnetfeldlinien durch die Wandflächen 9e und 9d betrug außen 20 Grad und innen 15 Grad. Der Durchmesser der äußeren Wandfläche betrug 153 mm, derjenige der inneren Wandfläche 70 mm. Das Diagramm gemäß Figur 4 zeigt auf der Abszisse den Zerstäubungsstrom in Ampere und auf der Ordinate die Zerstäubungsspannung in Volt. Die obere (kürzere) Kurve zeigt die Kennlinie, nachdem eine Arbeit von 3 kWh über die Katode geflossen ist; die untere (längere) Kurve, zeigt die Kennlinie, nachdem eine Arbeit von 140 kWh über die Katode geflossen ist. Bemerkenswert ist hierbei der besonders flache Verlauf, mit dem sich die Kennlinien an einem Grenzwert (gestrichelte horizontale Linie) annähern. Daraus ist ersichtlich, daß sich die Stromaufnahme beträchtlich steigern läßt, ohne daß die Spannung wesentlich erhöht werden müßte. In allen Fällen war die maximal einkoppelbare leistungsdichte (bezogen auf die zwischen den Wandflächen eingeschlossene Zerstäubungsfläche) deutlich größer als 120 W/cm². Die mittlere spezifische Niederschlagsrate betrug gegenüber der Zerstäubungsfläche 0,75 nm/sec pro W/cm². Dabei war die Ratenverteilung weitgehend unabhängig von der gesamten Zerstäubungsleistung. Nach einer gesamten Zerstäubungsarbeit von 140 kWh wurde ein Materialwirkungsgrad von 58,9 % gemessen und errechnet, und die integrierte spezifische Zerstäubungsrate betrug 611 mm³/kWh.

Der Gesamtaufbau der Zerstäubungskatode ist in Figur 6 dargestellt.

Während die Figuren 1 und 2 einen radialen Axialschnitt durch jeweils eine rotationssymmetrische Zerstäubungskatode zeigen, ist in Figur 4 in perspektivischer Darstellung ein Target 39 dargestellt, wie es besonders zweckmäßig für sogenannte Langkatoden verwendet wird. Man kann sich das Target 39 nach Figur 4 in der Weise zustandegekommen denken, daß man ein Target mit einer kreisringförmigen Projektionsfläche nach Figur 1 in einer diametralen Ebene auseinanderschneidet und einen langgestreckten Abschnitt 39f einfügt. Die Zerstäubungsfläche 39a hat alsdann die Form einer "Rennbahn", die auf beiden Seiten von den senkrechten Vorsprüngen 39b und 39c mit den Wandflächen 39d und 39e begrenzt ist. In der Mitte des langgestreckten Ovals befindet sich eine durchgehende Öffnung 39g durch das Befestigungsmittel hindurchgeführt werden können, die hier nicht dargestellt sind. Das Target 39 wird auf seinem Gesamtumfang innen und außen von einem geometrisch ähnlich geformten Magnetsystem begleitet, wie dies aus Figur 1 ersichtlich ist. Ein derartiges Target läßt sich auf besonders einfache Weise durch einen Gießvorgang herstellen. Auch ist ein Herstellvorgang denkbar, bei dem die bogenförmigen Endstücke durch Zersägen eines Gußkörpers hergestellt werden, während die dazwischen eingefügten linearen Teilstücke aus einem Strangprofil oder aus einem gebogenen Profil bestehen.

Bei Verwendung sogenannter Langkatoden mit Target 39 nach Figur 4 werden die Substrate üblicherweise quer zu den geradlinig verlaufenden Teilen der Zerstäubungsflächen 39a bewegt. Hieraus ergibt sich, daß mit zunehmender Breite der Substrate lediglich die Länge des Abschnitts 39f vergrößert werden muß, nicht aber der Abstand zwischen den Vorsprüngen 39b und 39c.

Figur 4 zeigt auch, was unter der Angabe zu verstehen ist, daß die Vorsprünge 39b und 39c in sich geschlossen und konzentrisch ineinander angeordnet sind: Es handelt sich darum, daß die genannten Vorsprünge endlos sind und einen Trog von im wesentlichen gleichbleibender Breite zwischen sich einschliessen. Die Massenschwerpunkte beider Vorsprünge fallen jedenfalls zusammen.

Figur 6 zeigt eine vollständige Zerstäubungskatode, in die im Prinzip jedes der Targets aus den Figuren 1 und 2 einbaubar ist.

Dort ist eine Stromzuführungsplatte 1 dargestellt, die über einen Stützisolator 2 mit einer Vakuumkammer 3 verbunden ist, die ihrerseits an Masse 4 liegt. Die Stromzuführungsplatte 1 ist über eine Leitung 41 mit einer Stromversorgungseinheit 40 verbunden, die für das Zerstäuben von metallischen bzw. elektrisch leitfähigen Targets als Gleichspannungsquelle ausgebildet ist.

Mit der Stromzuführungsplatte 1 ist der Katodengrundkörper 5 isoliert aber fest verbunden, und zwar unter Zwischenschaltung von Isolierkörpern 15 mit Kragen 15a, von denen mehrere auf den Umfang verteilt sind, von denen jedoch nur einer im Schnitt gezeigt ist. Das Target 9 entspricht im vorliegenden Falle weitgehend demjenigen nachFigur 1, wobei lediglich die Kühlkanäle 12 durch ein bifilar gewickeltes Rohr mit quadratischem Querschnitt gebildet werden, das zwischen dem Target 9 und dem Isolierkörper 12 durch mehrere auf den Umfang verteilte Zugschrauben 10 eingespannt wird, um einen guten Wärmeübergang zu gewährleisten.

Die Zugschrauben 10 durchdringen die Stromzuführungsplatte 1 und - unter Zwischenschaltung der Isolierkörper 15 - auch den Katodengrundkörper 5 und stellen die elektrische Verbindung mit dem Target 9 her. Zu diesem Zweck ist das Target 9 an seiner Unterseite mit einer umlaufenden Rippe 9f mit Gewindebohrungen versehen, in die die Zugschrauben 10 eingreifen.

Die abgewinkelten Enden 12b und 12c sind mit ausreichenden Isolierabständen durch Bohrungen im Katodengrundkörper 5 sowie durch eine radiale Ausnehmung 1a in der Stromzuführungsplatte hindurchgeführt.

Es ist durch entsprechende Wahl der Dicke des Isolierkörpers 11 und/oder der axialen Länge der Polschuhe 23 und 24 möglich, die Zerstäubungsfläche 9a in eine bestimmte räumliche Lage zu den Polflächen 23a und 24a zu bringen (rechte Seite von Figur 6).

Es ist erkennbar, daß wegen der Isolierkörper 11 und 15 die Stromzuführungsplatte 1 und das Target 9 sowohl gegenüber dem Katodengrundkörper 5 mit dem Magnetsystem 7 als auch gegenüber der Vakuumkammer 3 bzw. der Masse 4 elektrisch isoliert sind. Während das Target 9 über die Stromzuführungsplatte 1 auf ein definiertes negatives Potential gebracht werden kann, und auch die Masse 4 ein definiertes Potential (0-Potential) darstellt, ist der Katodengrundkörper 5 mit dem Magnetsystem 7 und der Abschirmung 16 elektrisch frei und kann sich auf ein durch die Betriebsbedingungen vorgegebenes Zwischenpotential einstellen, bei dessen Erreichen sich innerhalb allerkürzester Zeit selbsttätig der Effekt einstellt, daß eine Zerstäubung der Abschirmung 16 und damit des Magnetsystems 7 unterbleibt. Die Stromzuführungsplatte 1 kann mit einer (nicht dargestellten) Dunkelraumabschirmung versehen sein, so daß auch eine Zerstäubung der Stromzuführungsplatte nach der Rückseite hin ausgeschaltet wird.

Wie bereits anhand der Figuren 4 und 5 erläutert wurde, ist die Erfindung keineswegs auf eine rotationssymmetrische Anordnung beschränkt. Der Querschnitt gemäß Figur 6 (ein Axialschnitt) steht auch stellvertretend für einen Querschnitt durch eine sogenannte Langkatode mit einem Target 39 nach Figur 5. Man muß sich die Zerstäubungskatode dann lediglich in senkrechter Richtung zur Zeichenebene entsprechend verlängert denken. Derartige Katoden können bei einer Breite von etwa 30 bis 40 cm ohne weiteres Baulängen von etwa 4 m erreichen. Auch sind alle Zwischenformen zwischen der Kreisform und der Rechteckform denkbar. Ein Substrat 30 kann dann bei seiner Relativverschiebung in Richtung des Pfeils 30a gegenüber der Katode äußerst gleichförmig beschichtet werden.

Es ist dabei besonders vorteilhaft, wenn die Projektionsflächen von Permanentmagneten 7a und 7b einerseits und Polschuhen 23 und 24 andererseits im wesentlichen kongruent sind. Gemeint sind dabei die Projektionsflächen in eine Ebene, die parallel zur Zerstäubungsfläche verläuft.

Es ist weiterhin von Vorteil, wenn die dem Grundkörper abgekehrten Endflächen 7c und 7d der Permanentmagnete 7a und 7b gegenüber der Zerstäubungsfläche 9a bzw. 29a zurückgesetzt sind und wenn sich die Polflächen 23a und 24a der Polschuhe 23 und 24 in normalen Richtung zur Zerstäubungsfläche bis in den Bereich der Vorsprünge 9b/9c bzw. 29b/29c bzw. 39b/39c erstrekken.

Schließlich ist es von besonderem Vorteil, wenn die Stirnseiten der Polschuhe 23 und 24 gegenüber den Stirnseiten der Vorsprünge in Normalen-Richtung zur Zerstäubungsfläche zurückgesetzt sind.

Auf die angegebene Weise liegen die Austrittsstellen der magnetischen Feldlinien in dem Bereich, der für eine möglichst gleichförmige Zerstäubung über eine lange Betriebsdauer und bei weitgehender Ausnutzung des Targetmaterials eines **dicken** Targets optimal ist.

**Patentansprüche**

1. Zerstäubungskatode für die Beschichtung von Substraten (30) in Katodenzerstäubungsanlagen mit einem Katodengrundkörper (5) und einem darauf angeordneten Target (9, 29) aus amagnetischem Material mit einer Zerstäubungsfläche (9a, 29a), mit einem Permanentmagnete aufweisenden Magnetsystem (7) mit an Luft angrenzenden Polflächen für den Ein- und Austritt der Magnetfeldlinien zur Erzeugung eines in sich geschlossenen, die Zerstäubungsfläche (9a, 29a) übergreifenden Tunnels aus Magnetfeldlinien und mit einer nicht der Zerstäubung dienende Flächen abdeckenden Abschirmung (16), die mindestens das Magnetsystem übergreift, wobei

    a) das Target (9, 29, 39) mit mindestens zwei in sich geschlossenen, konzentrisch ineinanderliegenden, aus ausschließlich amagnetischem Material bestehenden Vorsprüngen (9b, 9c; 29b, 29c; 39b, 39c) versehen ist, die mindestens eine Zerstäubungsfläche (9a, 29a, 39a) zwischen sich einschließen und aufeinander zugerichtete Wandflächen (9d, 9e; 29d, 29e; 39d, 39e) aufweisen, deren Erzeugende im wesentlichen senkrecht zur Zerstäubungsfläche (9a) verlaufen, wobei

b) die Polflächen (23a, 24a) beiderseits der Vorsprünge (9b, 9c; 29b, 29c; 39b, 39c) und der zwischen ihnen liegenden Zerstäubungsfläche (9a, 29a, 39a) soweit über die Ebene (E-E), in der die Zerstäubungsfläche (9a, 29a, 39a) liegt, in Zerstäubungsrichtung vorgezogen sind, daß ein wesentlicher Teil der Magnetfeldlinien in im wesentlichen senkrechter Richtung aus der einen Wandfläche (9e, 29e, 39e) des einen Vorsprungs (9c, 29c, 39c) austritt und nach dem Überqueren der Zerstäubungsfläche (9a, 29a, 39a) in die andere, gegenüberliegende Wandfläche (9d, 29d, 39d) des anderen Vorsprungs (9b, 29b, 39b) in im wesentlichen senkrechter Richtung wieder eintritt,

**dadurch gekennzeichnet**, daß

c) die Magnetisierungsrichtung der Permanentmagnete (7a, 7b) des Magnetsystems (7, 37) parallel zu den Vorsprüngen (9b, 9c; 29b, 29c; 39b, 39c) verläuft und daß die Permanentmagnete (7a, 7b) auf den den Vorsprüngen abgekehrten Seiten durch den zur Zerstäubungsfläche (9a, 29a, 39a) geometrisch ähnlichen, weichmagnetischen Grundkörper (5) verbunden und auf den den Vorsprüngen (9b, 9c; 29b, 29c; 39b, 39c) zugekehrten Seiten mit weichmagnetischen Polschuhen (23, 24) versehen sind, die sich über mindestens einen Teil der Höhe der Vorsprünge (9b, 9c) erstrecken,

d) die Projektionsflächen von Permanentmagneten (7a, 7b) und Polschuhen (23, 24) im wesentlichen kongruent sind, und daß

e) die Stirnseiten der Polschuhe (23, 24) gegenüber den Stirnseiten der Vorsprünge (9b, 9c; 29b, 29c; 39b, 39c) in Normalrichtung zur Zerstäubungsfläche zurückgesetzt sind.

2. Zerstäubungskatode nach Anspruch 1, **dadurch gekennzeichnet**, daß die dem Grundkörper (5) abgekehrten Endflächen (7c, 7d) der Permanentmagnete (7a, 7b) gegenüber der Zerstäubungsfläche (9a, 29a) zurückgesetzt sind und daß sich die Polflächen (23a, 24a) der Polschuhe (23, 24) in Normalrichtung zur Zerstäubungskatode bis in den Bereich der Vorsprünge (9b, 9c; 29b, 29c; 39b, 39c) erstrecken.

**Claims**

1. Sputtering cathode for coating substrates (30) in cathode sputtering installations having a cathode base element (5) and, disposed thereon, a target (9, 29) of non-magnetic material with a sputtering surface (9a, 29a), having a magnetic system (7) with permanent magnets and air-exposed pole faces for the entry and exit of the magnetic lines of force for producing a self-contained tunnel of magnetic lines of force which overlaps the sputtering surface (9a, 29a), and having a screen (16) which covers surfaces not used for sputtering and overlaps at least the magnetic system, wherein

a) the target (9, 29, 39) is provided with at least two self-contained projections (9b, 9c; 29b, 29c; 39b, 39c) made exclusively of non-magnetic material and lying concentrically one inside the other, which between them enclose at least one sputtering surface (9a, 29a, 39a) and have wall surfaces (9d, 9e; 29d, 29e; 39d, 39e) which are directed towards one another and whose generatrix extends substantially perpendicular to the sputtering surface (9a), wherein

b) the pole faces (23a, 24a) on either side of the projections (9b, 9c; 29b, 29c; 39b, 39c) and of the sputtering surface (9a, 29a, 39a) lying between them are drawn forward in sputtering direction so far beyond the plane (E-E) in which the sputtering surface (9a, 29a, 39a) lies, that a substantial portion of the magnetic lines of force exits in a substantially perpendicular direction from the one wall surface (9e, 29e, 39e) of the one projection (9c, 29c, 39c) and, after crossing the sputtering surface (9a, 29a, 39a), re-enters the other opposing wall surface (9d, 29d, 39d) of the other projection (9b, 29b, 39b) in a substantially perpendicular direction,

characterised in that

c) the direction of magnetisation of the permanent magnets (7a, 7b) of the magnetic system (7, 37) extends parallel to the projections (9b 9c; 29b, 29c; 39b, 39c), and that the permanent magnets (7a, 7b), on the sides remote from the projections, are connected by the soft magnetic base element (5) which is geometrically similar to the sputtering surface (9a, 29a, 39a) and, on the sides facing the projections (9b, 9c; 29b, 29c; 39b, 39c), are provided with soft magnetic pole shoes (23, 24) which extend over at least part of the height of the projections (9b, 9c),

d) the projection surfaces of permanent magnets (7a, 7b) and pole shoes (23, 24) are substantially congruent, and that

e) the faces of the pole shoes (23, 24) are set back relative to the faces of the projections (9b, 9c; 29b, 29c; 39b, 39c) in a normal direction to the sputtering surface.

2. Sputtering cathode according to claim 1, characterised in that the end faces (7c, 7d) of the permanent magnets (7a, 7b) remote from the base element (5) are set back relative to the sputtering surface (9a, 29a), and that the pole faces (23a, 24a) of the pole shoes (23, 24) extend in a normal direction to the sputtering cathode as far as into the region of the projections (9b, 9c; 29b, 29c; 39b, 39c).

**Revendications**

1. Cathode de pulvérisation pour le revêtement de substrats (30) dans des installations de pulvérisation cathodique, comprenant un corps de base (5) de la cathode et une cible (9, 29) de matériau amagnétique disposée sur ce corps de base et présentant une aire de pulvérisation (9a, 29a), un système magnétique (7), comportant des aimants permanents, avec des faces polaires adjacentes à l'air pour l'entrée et la sortie des lignes de champ magnétique servant à la création d'un tunnel de lignes de champ magnétique fermé en lui-même et s'étendant par-dessus l'aire de pulvérisation (9a, 29a), ainsi qu'un blindage (16), recouvrant les surfaces ne servant pas à la pulvérisation, qui s'étend au moins par-dessus le système magnétique, dans laquelle

a) la cible (9, 29, 39) est pourvue d'au moins deux saillies (9b, 9c; 29b, 29c; 39b, 39c) fermées en elles-mêmes, disposées concentriquement l'une dans l'autre et faites de matériau exclusivement amagnétique, qui renferment entre elles au moins une aire de pulvérisation (9a, 29a, 39a) et présentent des faces de parois (9d, 9e; 29d, 29e; 39d, 39e) dirigées l'une vers l'autre et dont les génératrices sont essentiellement perpendiculaires à l'aire de pulvérisation (9a), et dans laquelle

b) les faces polaires (23a, 24a) des deux côtés des saillies (9b, 9c; 29b, 29c; 39b, 39c) et de l'aire de pulvérisation (9a, 29a, 39a) située entre elles, sont avancées à tel point, dans la direction de pulvérisation, au-delà du plan (E-E) dans lequel est située l'aire de pulvérisation (9a, 29a, 39a), qu'une partie essentielle des lignes de champ magnétique émerge essentiellement en direction perpendiculaire de la face de paroi (9e, 29e, 39e) d'une saillie (9c, 29c, 39c) et, après avoir traversé l'aire de pulvérisation (9a, 29a, 39a), pénètre de nouveau en direction essentiellement perpendiculaire dans l'autre face de paroi (9d, 29d, 39d), située à l'opposé, de l'autre saillie (9b, 29b, 39b),

caractérisée en ce que

c) la direction d'aimantation des aimants permanents (7a, 7b) du système magnétique (7, 37) est parallèle aux saillies (9b, 9c; 29b, 29c; 39b, 39c) et que les aimants permanents (7a, 7b) sont reliés, sur les côtés éloignés des saillies, par le corps de base (5), lequel est géométriquement analogue à l'aire de pulvérisation (9a, 29a, 39a) et réalisé de matériau magnétique doux, et sont pourvus, sur les côtés dirigés vers les saillies (9b, 9c; 29b, 29c; 39b, 39c), de pièces polaires (23, 24) en matériau magnétique doux, qui s'étendent sur une partie au moins de la hauteur des saillies (9b, 9c),

d) les surfaces de projection des aimants permanents (7a, 7b) et des pièces polaires (23, 24) ont des formes essentiellement identiques et qui se recouvrent, et que

e) les côtés d'extrémités des pièces polaires (23, 24) sont disposés en retrait par rapport aux côtés d'extrémités des saillies (9b, 9c; 29b, 29c; 39b, 39c) en direction normale à l'aire de pulvérisation.

2. Cathode de pulvérisation selon la revendication 1, caractérisée en ce que les faces d'extrémité (7c, 7d) éloignées du corps de base (5) des aimants permanents (7a, 7b) sont disposées en retrait par rapport à l'aire de pulvérisation (9a, 29a), et que les faces polaires (23a, 24a) des pièces polaires (23, 24) s'étendent, en direction normale à la cathode de pulvérisation, jusque dans la région des saillies (9b, 9c; 29b, 29c; 39b, 39c).

FIG.1

FIG.2

## FIG.3

## FIG.5

FIG. 4

FIG.6

EP 0 210 473 B1